# EUROPÄISCHE PATENTSCHRIFT

(11) **EP 2 595 095 B1**
(45) Veröffentlichungstag und Bekanntmachung des Hinweises auf die Patenterteilung: **13.07.2016**
(21) Anmeldenummer: 13000069.8
(22) Anmeldetag: 12.08.2010
(51) Int. Cl.: G06K 19/077, H01L 23/13, H01L 23/498, H01L 23/52, H05K 3/32

(54) **Portabler Datenträger**
Portable data carrier
Support de données portable

(30) Priorität: 14.08.2009 DE 102009037627
(43) Veröffentlichungstag der Anmeldung: 22.05.2013
(62) Teilanmeldung aus: 10008397.1
(73) Patentinhaber: Giesecke & Devrient GmbH, 81677 München (DE)
(72) Erfinder: Olbrich, Magnus, 81543 München (DE)

(56) Entgegenhaltungen:
- EP-A2- 1 093 160
- WO-A1-00/36557
- WO-A2-2009/026998
- DE-A1-102004 010 715
- DE-A1-102004 053 292
- US-A1- 2002 192 856

## Beschreibung

Die vorliegende Erfindung betrifft einen portablen Datenträger mit einem in einen Datenträgerkörper des Datenträgers eingebetteten elektronischen Modul, ein entsprechendes Modul, einen Datenträgerkörper, ein elektrisch leitfähiges Material zum Verbinden des Moduls mit einer elektrischen Komponente des Datenträgerkörpers sowie ein Verfahren zum Herstellen eines solchen Datenträgers.

Portable, meist kartenförmige Datenträger, insbesondere Chipkarten, werden in vielen Bereichen eingesetzt, beispielsweise als Ausweisdokumente, zum Nachweis einer Zugangsberechtigung zu einem Mobilfunknetz oder zur Durchführung von Transaktionen des bargeldlosen Zahlungsverkehrs. Eine Chipkarte weist einen Kartenkörper und einen in den Kartenkörper eingebetteten integrierten Schaltkreis auf. Um eine effiziente Herstellung der Chipkarte zu ermöglichen, wird der integrierte Schaltkreis bei einer Vielzahl von Herstellungsverfahren zunächst in ein Chipmodul verpackt und anschließend wird das Chipmodul in den Kartenkörper eingebaut. In der Regel wird das Chipmodul in eine Aussparung des Kartenkörpers eingeklebt.

Eine Kommunikation mit dem integrierten Schaltkreis kann über ein Kontaktfeld der Chipkarte abgewickelt werden, das hierzu von einer Kontaktiereinheit berührend kontaktiert wird. Das Kontaktfeld ist in der Regel Bestandteil des Chipmoduls. Alternativ oder zusätzlich zur Kommunikation über das Kontaktfeld kann eine kontaktlose Kommunikation vorgesehen sein.

Hierzu kann der Kartenkörper eine Antennenspule aufweisen, die beim Einbau des Chipmoduls mit dem integrierten Schaltkreis elektrisch leitend verbunden wird. Abhängig vom Einsatzgebiet der Chipkarte kann der Kartenkörper außer der Antennenspule auch andere oder weitere elektrische Komponenten aufweisen, die beim Einbau des Chipmoduls mit dem integrierten Schaltkreis elektrisch leitend verbunden werden.

Bei der überwiegenden Zahl der für den Einbau eines Chipmoduls in einen Kartenkörper verwendeten Techniken sind die Bereiche, in denen die elektrisch leitenden Verbindungen zwischen dem integrierten Schaltkreis des Chipmoduls und der elektrischen Komponente des Kartenkörpers ausgebildet werden, nicht direkt mittels eines Werkzeugs zugänglich. Es sind daher Kontaktierungsverfahren erforderlich, die trotz dieser fehlenden Zugangsmöglichkeit eine Ausbildung einer elektrisch leitenden Verbindung zwischen dem integrierten Schaltkreis und der elektrischen Komponente ermöglichen.

Gemäß der DE 10 2004 053 292 A1 wird ein elektrisch leitender Kontakt zwischen einer Kontakteinrichtung einer elektrischen Komponente des Datenträgerkörpers, beispielsweise einer Antennenspule, und einer Kontakteinrichtung eines elektronischen Moduls, beispielsweise eines Chipmoduls, dadurch hergestellt, dass die jeweiligen Kontakteinrichtungen mittels ineinander greifender Anordnungen kraftschlüssig miteinander verbunden werden. Der DE 2005 002 731 A1 folgend wird das Modul derart in den Datenträgerkörper eingepresst, dass die entsprechenden Kontakteinrichtungen, die jeweils als glatte Flächen ausgebildet sind, gegeneinander gepresst werden. In der DE 10 2004 053 291 A1 werden die jeweiligen Kontakteinrichtungen durch eine Legierung stoffschlüssig miteinander verbunden, welche jeweils ein auf die beiden Kontakteinrichtungen aufgebrachtes Material umfasst. Gemäß der DE 10 2005 002 733 A1 ist die Kontakteinrichtung des Moduls als ein elektrisch leitfähiges Band ausgebildet, welches mittels spitz zulaufender Erhebungen, welche eine elektrisch isolierende Schicht durchdringen, die Kontakteinrichtung der elektrischen Komponente des Datenträgerkörpers kontaktieren.

Die DE 10 2005 002 726 A1, DE 10 2005 002 732 A1 sowie die DE 10 2005 002 728 A1 lehren, die Kontakteinrichtung der elektrischen Komponente des Datenträgers mit der Kontakteinrichtung des elektronischen Moduls, welche jeweils verschiedenartig ausgebildet sind, mittels eines leitfähigen Materials elektrisch leitend zu verbinden, vorzugsweise mittels eines Lots oder eines aushärtenden Leitklebers, wodurch die beiden Kontakteinrichtungen stoffschlüssig miteinander verbunden werden.

Die verschiedenen Arten der Verbindung zwischen den beiden Kontakteinrichtungen, wie sie vorstehend skizziert worden sind, haben den Nachteil, dass eine derart kraftschlüssig oder stoffschlüssig hergestellte Verbindung aufgrund der starken mechanischen Beanspruchungen an den Datenträger leicht unterbrochen werden kann, wenn sich das Modul relativ zu dem Datenträgerkörper, wenn auch nur geringfügig, verschiebt. Unmittelbar kontaktierte Kontakteinrichtungen können dabei den Kontakt verlieren, stoffschlüssige Verbindungen aufbrechen.

Gemäß der DE 102 57111 A1 wird ein elastisches, elektrisch leitfähiges Material zum Verbinden des Moduls mit der Komponente des Datenträgers verwendet, wobei das Material beim Einbetten des Moduls in den Datenträgerkörper durch die Kontakteinrichtung des elektrischen Moduls des Datenträgerkörpers und der Kontakteinrichtung des Moduls zusammengedrückt wird. Bei nachlassender Druckbeaufschlagung des Materials, beispielsweise aufgrund einer vertikalen Verschiebung des Moduls in dem Datenträgerkörper aufgrund einer Biegebelastung auf den Datenträger, kann die Verbindung zumindest solange aufrechterhalten werden, wie die Elastizität des Materials diese Verschiebung ausgleichen kann, was allerdings nur in begrenztem Maße möglich ist.

DE 10 2004 010 715 A1, das als nächtliegendster Stand der Technik gesehen wird, offenbart eine Chipkarte zur kontaktlosen Datenübertragung, die zusammengesetzt ist aus einem Chipmodul und einem Kartenkörper. Das Chipmodul umfasst einen Träger mit einer ersten Seite und einer zweiten Seite, einen Halbleiterchip auf der ersten Seite, einem Kontaktvermittler auf der ersten Seite sowie einer elektrisch leitenden Verbindung zwischen dem Halbleiterchip und dem Kontaktvermittler. Der Kartenkörper umfasst eine Antenne für eine induktive Datenübertragung und eine freigelegte Anschlussstelle der Antenne. Zwischen der ersten Seite und der freigelegten Anschlussstelle befindet sich ein elektrisch leitfähiges Mittel zum Verbinden der Antenne mit dem Halbleiterchip. In dieses elektrisch leitfähige Mittel ragt der Kontaktvermittler hinein.

US 2002/192 856 A1 betrifft ein Verfahren zum Verbinden eines Chips mit einer kontaktlosen Chipkartenantenne mit verformbaren Kontakten, wobei die Antenne mit einer leitfähigen Tinte auf einen Antennenträger gedruckt ist, der aus einem verformbaren Material hergestellt ist. Dieses Verfahren umfasst zwei Schritte. Im ersten Schritt wird der Chip, welcher mit Kontakten aus einem nicht verformbaren Material ausgestattet ist, auf dem Antennenträger positioniert, so daß die Kontakte gegenüber den Kontakten der Antenne liegen. Im zweiten Schritt wird eine Kraft auf den Chip ausgeübt, so daß die Kontakte als ein Ergebnis des Drucks die Antennenhalterung und die Kontakte der Antenne verformen, wobei der Träger und die Kontakte die Verformung beibehalten, wenn der Druck nachlässt, so dass eine signifikante Kontaktfläche zwischen den Kontakten des Chips und den Kontakten der Antenne erhalten wird.

WO 2009 / 026 998 A2 offenbart eine Verbindung eines mit Anschlussflächen bzw. Bumps versehenen Chips für eine Herstellung von Chipmodulen, Tags, Inlays für textile Etiketten, Chipkarten oder dergleichen, mit einem Laminat aus metallischen Leiterbahnen und einem Substrat insbesondere aus polymeren Kunststoffen und mit Verbindungsmitteln zur Verbindung der Anschlussflächen bzw. Bumps mit den Leiterbahnen, wobei die Leiterbahnen Antennenstrukturen für Transponder bilden oder nach außen führende elektrische Kontakte für eine nachträgliche Verbindung mit Antennenstrukturen aufweisen, dadurch gekennzeichnet, dass das Laminat mit Öffnungen und/oder Vertiefungen versehen ist, in welche die Chip-Anschlussflächen und/oder der komplette Chip mit mindestens einem Teil der Höhe eingetaucht sind, und in welcher die elektrische Verbindung des Chips über das in der korrespondierenden Öffnung liegende Verbindungsmittel mit der jeweiligen Leiterbahn erfolgt.

EP 1 093 160 A2 offenbart ein Verfahren zur Herstellung einer elektrisch leitenden Verbindungsanordnung, bei der ein Halbleiterelement mit einer Vielzahl von Elektroden, die in der Außenseite einer Passivierungsschicht, die auf dem Halbleiterelement ausgebildet ist, ausgespart sind, mit einer Substratleiterplatte, die eine Vielzahl von Elektroden in einer korrespondierend gegenüberstehenden Beziehung zu den Elektroden des Halbleiterelements aufweist, verklebt und elektrisch leitend verbunden wird unter Verwendung eines elektrisch anisotrop leitenden Verbindungsmaterials, umfassend die folgenden Schritte:
Anordnen eines Verbindungsmaterials, umfassend eine isolierende Klebstoffkomponente, die ein wärmehärtbares Harz enthält, und elektrisch leitende Partikel, zwischen dem Halbleiterelement und der Substratleiterplatte und Härten des Verbindungsmaterials während des Heißpressens des Halbleiterelements und der Substratleiterplatte aufeinander, wobei jedes der elektrisch leitenden Partikel ein HarzkernPartikel mit einer Metallschicht beinhaltet, die zusätzlich mit einer Schicht eines elektrisch isolierenden Harzes beschichtet ist, wobei das isolierende Harz in der Klebstoffkomponente des Verbindungsmaterials unlöslich oder schwer löslich ist und während dem genannten Heißpressen geschmolzen oder zerstört wird, und wobei die durchschnittliche Partikelgröße der elektrisch leitenden Partikel wenigstens das 1,5-fache der Aussparungstiefe der Elektroden an der Außenseite der Passivierungsschicht des Halbleiterelements beträgt und im Bereich des 0,01 bis 0,5-fachen des Abstandes zwischen benachbarten Elektroden liegt, die Härte (K-Wert) der elektrisch leitenden Partikel im Bereich von 500 bis 10.000 N/mm2 und die Mohs-Härte der Metallbeschichtung der elektrisch leitenden Partikel im Bereich von 1 bis 6 liegt und wobei die Passivierungsschicht aus Polyimidharz, Polybenzocyclobuten oder Polytetrafluoroethylen hergestellt ist.

Aufgabe der vorliegenden Erfindung ist es, eine weiter verbesserte, auf den Datenträgerkörper einwirkenden mechanischen Belastungen standhaltende elektrisch leitende Verbindung zwischen einer elektrischen Komponente eines Datenträgerkörpers und einem in den Datenträgerkörper eingebetteten Modul auf einfache Weise herzustellen.

Diese Aufgabe wird durch einen portablen Datenträger, ein Modul, einen Datenträgerkörper, ein elastisches, elektrisch leitfähiges Material sowie ein Verfahren zur Herstellung des Datenträgers mit den Merkmalen der unabhängigen Ansprüche gelöst. Vorteilhafte Ausgestaltungen und Weiterbildungen sind in den abhängigen Ansprüchen angegeben.

Ein erfindungsgemäßer Datenträger umfasst dabei einen Datenträgerkörper mit einer elektrischen Komponente sowie ein elektronisches Modul, welches zumindest teilweise in den Datenträgerkörper eingebettet ist und über eine Modulkontakteinrichtung des Moduls mittels eines elastischen, elektrisch leitfähigen Materials unter Druckbeaufschlagung elektrisch leitend mit einer Komponentenkontakteinrichtung der elektrischen Komponente des Datenträgers verbunden ist. Erfindungsgemäß ist die Modulkontakteinrichtung räumlich strukturiert ausgebildet und in das elastische, elektrisch leitfähige Material ist durch die räumlich strukturierte Modulkontakteinrichtung eine räumliche Struktur eingeprägt.

Ein erfindungsgemäßes elektronisches Modul ist geeignet, zumindest teilweise in einen Datenträgerkörper eines portablen Datenträgers eingebettet zu werden und umfasst eine Modulkontakteinrichtung zum elektrisch leitenden Verbinden des Moduls mit einem elastischen, elektrisch leitfähigen Material des Datenträgers. Erfindungsgemäß ist die Modulkontakteinrichtung derart räumlich strukturiert ausgebildet, dass sie geeignet ist, beim Einbetten des Moduls in den Datenträgerkörper unter Druckbeaufschlagung eine räumliche Struktur in das elastische, elektrisch leitfähige Material einzuprägen.

Ein erfindungsgemäßes elastisches, elektrisch leitfähiges Material ist geeignet zum elektrisch leitenden Verbinden eines elektronischen Moduls und einer elektrischen Komponente eines portablen Datenträgers beim zumindest teilweisen Einbetten des Moduls in einen Datenträgerkörper des Datenträgers. Das Material ist erfindungsgemäß derart ausgebildet, dass beim Einbetten des Moduls in den Datenträgerkörper durch die räumliche Strukturierung der Modulkontakteinrichtung unter Druckbeaufschlagung eine räumliche Struktur in das Material eingeprägt wird.

Ein erfindungsgemäßer Datenträgerkörper mit einer elektrischen Komponente ist demnach geeignet zum Herstellen eines erfindungsgemäßen Datenträgers durch zumindest teilweises Einbetten eines erfindungsgemäßen Moduls und elektrisches Verbinden der Modulkontakteinrichtung des Moduls mit einer Komponentenkontakteinrichtung der elektrischen Komponente mittels eines erfindungsgemäßen elastischen, elektrisch leitfähigen Materials unter Druckbeaufschlagung des Materials durch die Modulkontakteinrichtung.

Gemäß einem erfindungsgemäßen Verfahren zur Herstellung eines portablen Datenträgers mit einem Datenträgerkörper sowie einem elektronischen Modul werden in einem ersten Schritt ein entsprechender Datenträgerkörper mit einer elektrischen Komponente, ein elektronisches Moduls sowie ein elastisches, elektrisch leitfähiges Material bereitgestellt. Danach wird das Material in einer Aussparung des Datenträgerkörpers derart angeordnet, dass das Material mit einer Komponentenkontakteinrichtung der elektrischen Komponente des Datenträgerkörpers elektrisch leitend verbunden wird. In einem weiteren Schritt wird das Modul in den Datenträgerkörper zumindest teilweise derart eingebettet, dass das Material die Komponentenkontakteinrichtung und eine Modulkontakteinrichtung des Moduls unter Druckbeaufschlagung elektrisch leitend verbindet. Erfindungsgemäß wird die Modulkontakteinrichtung räumlich strukturiert ausgebildet und das Material wird beim Einbetten des Moduls durch die Modulkontakteinrichtung räumlich strukturiert geprägt.

Dadurch, dass die Modulkontakteinrichtung räumlich strukturiert ausgebildet ist und beim Einbetten des Moduls in den Datenträgerkörper eine entsprechende räumliche Struktur in das derart eingerichtete elektrisch leitfähige Material eingeprägt wird, kann die zwischen dem Modul und der elektrischen Komponente des Datenträgerkörpers hergestellte elektrisch leitende Verbindung noch ausfallsicherer bereitgestellt werden. Durch das Einprägen der Struktur in das Material einerseits und die strukturierte Kontaktfläche der Modulkontakteinrichtung andererseits bleibt ein elektrisch leitender Kontakt zwischen der Modulkontakteinrichtung und dem Material auch bei Verschiebung des Moduls gegen den Datenträgerkörper aufgrund einer mechanischen Beanspruchung an den Datenträgerkörper, beispielsweise eine Biegung desselben, länger erhalten, als wenn die Kontaktfläche der Modulkontakteinrichtung flach ausgebildet wäre. Sowohl horizontale, insbesondere aber vertikale Verschiebungen des Moduls gegenüber dem Datenträgerkörper führen deswegen erst spät, d.h. bei sehr starker Verschiebung des Moduls, zu einer Unterbrechung der elektrisch leitenden Verbindung von Modul und elektrischer Komponente. Dies liegt daran, dass sich das elastische Material und die darin eingedrückte räumlich strukturierte Kontaktfläche der Modulkontakteinrichtung aufgrund der Elastizität des Materials und der Strukturierung der Kontaktfläche in einem Eingriff befinden, der sich auch bei nachlassender Druckbeaufschlagung des Materials durch die Modulkontakteinrichtung nur allmählich löst. Auf diese Weise ist die elektrisch leitende Verbindung auch bei starker mechanischer Beanspruchung an den Datenträger maximal lange stabil.

Die Herstellung des Datenträgers kann in bekannter, einfacher Weise durch Einbetten des Moduls in den Datenträgerkörper geschehen. Durch die dabei entstehende Druckbeaufschlagung des Materials durch die räumlich strukturierte Modulkontakteinrichtung wird das Material automatisch entsprechend geprägt. Bekannte Herstellungsverfahren müssen also lediglich hinsichtlich der Herstellung der räumlich strukturierten Kontaktfläche der Modulkontakteinrichtung und hinsichtlich der Bereitstellung eines geeigneten elastischen, elektrisch leitfähigen Materials, welches durch die strukturierte Modulkontakteinrichtung prägbar ist, angepasst werden. Sämtliche weiteren Produktionsschritte können unverändert bleiben.

Gemäß einer bevorzugten Ausführungsform ist das elastische, elektrisch leitfähige Material derart ausgebildet, dass die durch die räumlich strukturierte Modulkontakteinrichtung geprägte räumliche Struktur in dem Material auch bei nachlassender Druckbeaufschlagung des Materials im Wesentlichen erhalten bleibt. Dadurch kann der Kontakt zwischen der elektrischen Komponente und dem Modul über das elektrisch leitfähige Material auch bei einer starken vertikalen Verschiebung des Moduls gegenüber dem Datenträgerkörper erhalten werden, solange sich die Modulkontakteinrichtung vertikal entlang einer Flanke der Prägung des Materials verschiebt, auch wenn die Elastizität des Materials keine weitere vertikale Ausdehnung des Materials mehr erlaubt. Im Vergleich zur Verwendung einer herkömmlichen flachen, räumlich nicht strukturierten Modulkontakteinrichtung kann hier eine stärkere vertikale Verschiebung des Moduls ohne Kontaktunterbrechung gewährleistet werden. Die Verschiebung kann in vertikaler Richtung um eine Tiefe der eingeprägten, bei nachlassender Druckbeaufschlagung aufrechterhaltenen räumlichen Struktur des Materials größer ausfallen als bei Verwendung einer flachen Kontaktfläche, ohne dass der Kontakt abbricht.

Die Modulkontakteinrichtung ist zumindest teilweise flächig ausgebildet und eine beim Einbetten des Moduls in den Datenträgerkörper dem elastischen, elektrisch leitfähigen Material bzw. bei eingebettetem Modul im Datenträgerkörper der Komponentenkontakteinrichtung zugewandte Kontaktfläche der Modulkontakteinrichtung ist durch Aussparungen, insbesondere Rillen, Löcher oder dergleichen, räumlich strukturiert. Die Aussparungen können die gleichen oder aber verschiedene Tiefen aufweisen und als Muster, beispielsweise als Waffelmuster, oder aber zufällig angeordnet sein. Die Flanken der Aussparungen können jeden geeigneten Winkel zur Modulkontakteinrichtung einnehmen.

Gemäß einer bevorzugten Ausführungsform verjüngen sich zumindest einige der Aussparungen beim Einbetten des Moduls in Richtung des elastischen, elektrisch leitfähigen Materials bzw. bei eingebettetem Modul im Datenträger in Richtung der Komponentenkontakteinrichtung der elektrischen Komponente. Beim Einbetten des Moduls in diese sich verjüngenden Aussparungen eingedrungenes Material löst sich bei nachlassender Druckbeaufschlagung auf das Material bei vertikaler Verschiebung des Moduls aufgrund der sich verjüngenden Ausgestaltung der Aussparungen nur allmählich von der Kontaktfläche der Modulkontakteinrichtung, so dass der Kontakt zwischen dem Modul und der elektrischen Komponente auch bei starker vertikaler Verschiebung des Moduls im Datenträger aufrechterhalten werden kann.

Vorzugsweise sind die Aussparungen über die gesamte Kontaktfläche verteilt angeordnet. Die Erhebungen zwischen den Aussparungen sind zumindest teilweise miteinander elektrisch leitend verbunden. Dies gilt sowohl für die Erhebungen, welche mit dem elastischen, elektrisch leitfähigen Material verbunden sind, als auch für die Erhebungen, welche nicht mit dem elastischen, elektrisch leitfähigen Material verbunden sind. Dabei können sich die Aussparungen, die in den Randbereichen der Kontaktfläche angeordnet sind, von denen unterscheiden, die in einem zentralen Bereich der Kontaktfläche vorliegen, welche beispielsweise tiefer sein können. Es ist auch möglich, dass die Aussparungen über die gesamte Kontaktfläche gleichartig ausgebildet sind oder aber lediglich in vorgegebenen Teilbereichen der Kontaktfläche vorliegen.

Die Erfindung wird im Folgenden mit Bezug auf die beiliegenden Zeichnungen beispielhaft beschrieben. Darin zeigen:
- Figur 1: eine Draufsicht auf eine bevorzugte Ausführungsform eines erfindungsgemäßen Datenträgers;
- Figur 2: einen Ausschnitt eines Datenträgerkörpers des Datenträgers aus Fig. 1 in Draufsicht ohne eingebettetes elektronisches Modul;
- Figur 3: einen Ausschnitt einer bevorzugten Ausführungsform eines erfindungsgemäßen elektronischen Moduls in Schnittansicht;
- Figur 4: den Ausschnitt aus Fig. 3 in Untersicht;
- Figur 5: den Ausschnitt des Datenträgerkörpers aus Fig. 2 in Schnittansicht zusammen mit erfindungsgemäßem elastischem, elektrisch leitfähigem Material;
- Figur 6: den Ausschnitt aus Fig. 5 mit eingebettetem Modul aus Fig. 3; und
- Figur 7: einen vergrößerten Ausschnitt aus der Anordnung aus Fig. 6, wobei sich das Modul vertikal gegenüber dem Datenträgerkörper verschoben hat.

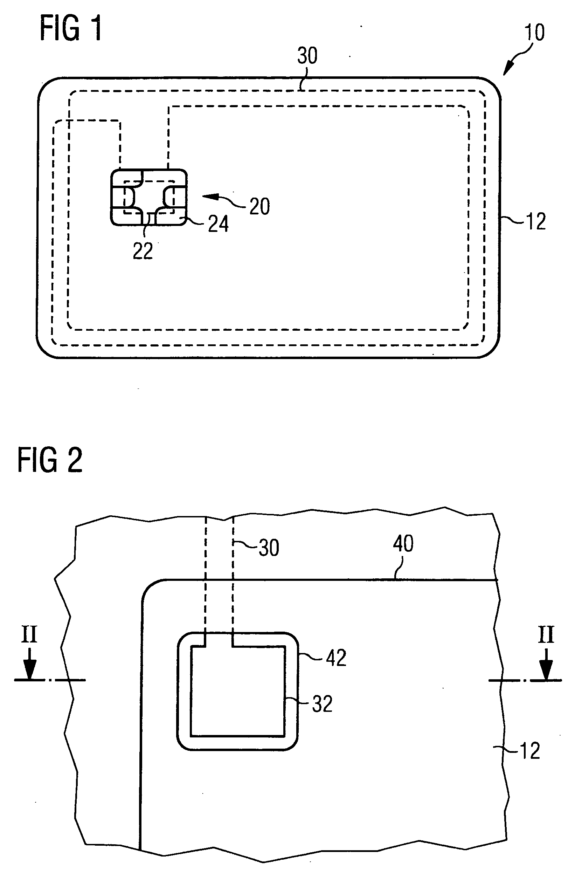

Figur 1 zeigt einen portablen Datenträger 10 in Form einer Chipkarte in einer schematischen Draufsicht. Der Datenträger 10 besitzt einen Datenträgerkörper 12, in den ein elektronisches Modul 20 in Form eines Chipmoduls eingebettet ist. Das Modul 20 umfasst einen integrierten Schaltkreis zum Speichern und/oder Verarbeiten von Daten, welcher in einen Vergusskörper 22 vergossen ist. Weiterhin verfügt das Modul 20 über ein Kontaktfeld 24, das an der Außenseite des Datenträgerkörpers 12 angeordnet ist und den im Inneren des Datenträgerkörpers 12 angeordneten integrierten Schaltkreis überdeckt. Zwischen dem integrierten Schaltkreis und dem Kontaktfeld 24 sind mehrere (nicht gezeigte) elektrisch leitende Verbindungen ausgebildet, so dass dem integrierten Schaltkreis über das Kontaktfeld 24 elektrische Signale zugeführt werden können und der elektrische Schaltkreis über das Kontaktfeld 24 Signale aussenden kann. Hierzu kann das Kontaktfeld 24 mit einem (nicht gezeigten) Lesegerät verbunden werden.

Der Datenträgerkörper 12 weist in seinem Inneren eine elektrische Komponente 30 in Form einer Antennenspule auf. Diese kann beispielsweise als gedruckte oder geätzte Spule oder als Drahtspule ausgebildet sein. Die Antenne 30 ist elektrisch leitend mit dem integrierten Schaltkreis verbunden und ermöglicht analog zum Kontaktfeld eine Übertragung von Signalen, die von dem Schaltkreis empfangen und/oder gesendet werden. Im Falle der Antennenspule 30 erfolgt eine entsprechende Datenübertragung kontaktlos. Dazu wird der Datenträger 10 in einem geeigneten Abstand zu einem (nicht gezeigten) Lesegerät angeordnet.

Alternativ oder zusätzlich zu der Antennenspule 30 können in dem Datenträgerkörper 12 des Datenträgers 10 aus Fig. 1 weitere (nicht dargestellte) elektrische Komponenten 30 angeordnet sein, beispielsweise eine Anzeige, ein Schalter, ein Sensor, eine Batterie und dergleichen. Auch diese elektrischen Komponenten können, wie nachfolgend detailliert beschrieben, mit dem integrierten Schaltkreis elektrisch leitend verbunden werden.

Fig. 2 zeigt den Datenträgerkörper 12 aus Fig. 1 vor dem Einsetzen des Moduls 20 ausschnittsweise in einer schematisierten Draufsicht. Der Datenträgerkörper 12 umfasst eine Aussparung 40, in die das Modul 20 zumindest teilweise eingebettet wird. Die Aussparung 40 ist mehrstufig ausgebildet und umfasst eine weitere Aussparung 42. Die Aussparung 42 ist im Vergleich zur Aussparung 40 tiefer ausgebildet. Am Boden der Aussparung 42 tritt eine Komponentenkontakteinrichtung 32 der elektrischen Komponente 30, welche ansonsten in dem Datenträgerkörper 12 unzugänglich eingebettet ist, hervor und ist dort direkt kontaktierbar. Die Komponentenkontakteinrichtung 32 ist einteilig mit der Komponente 30 ausgebildet. Es ist auch möglich, die Komponentenkontakteinrichtung 32 separat auszubilden und elektrisch leitend mit der Komponente 30 zu verbinden.

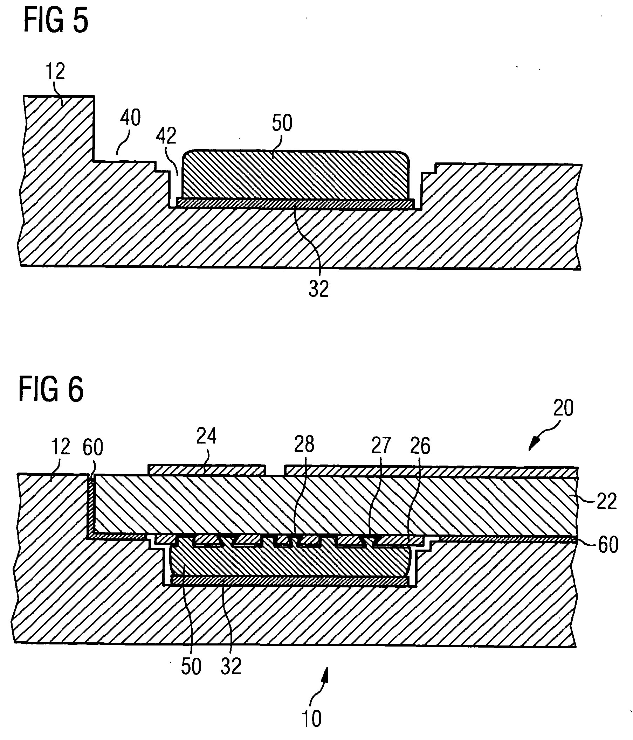

Fig. 5 zeigt den gleichen Ausschnitt des Datenträgerkörpers 12 in einer Schnittansicht entlang der Linie II-II aus Fig. 2, wobei in die Aussparung 42 zusätzlich eine Menge eines elastischen, elektrisch leitfähigen Materials 50 eingebracht worden ist, welches, wie nachfolgend detailliert beschrieben, zum elektrisch leitenden Verbinden des Moduls 20 mit der Komponente 30 dient. Der Datenträgerkörper 12 kann mittels verschiedener Verfahren gebildet werden, beispielsweise im Spritzgussverfahren oder durch Laminieren verschiedener Folien. Die Aussparungen 40, 42 können dabei in den Folien bereits vorgesehen sein, beispielsweise ausgestanzt, oder aber aus dem Datenträgerkörper herausgefräst werden.

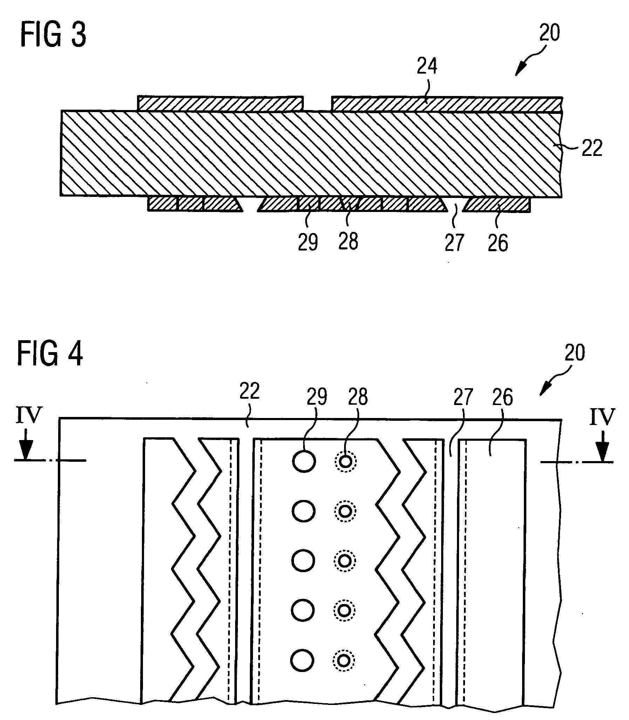

In Fig. 3 ist das elektronische Modul 20 ausschnittsweise in einer seitlichen Schnittansicht schematisch gezeigt. In dem Vergusskörper 22 ist der integrierten Schaltkreis geschützt vergossen. Das Kontaktfeld 24 und eine auf der Unterseite des Vergusskörpers 22 angeordnete Kontaktfläche einer Modulkontakteinrichtung 26 sind mit dem integrierten Schaltkreis elektrisch leitend, beispielsweise über (nicht gezeigte) Bond-Drähte, verbunden. Die Modulkontakteinrichtung 26 in Form der gezeigten Kontaktfläche ist räumlich strukturiert ausgebildet und umfasst dazu Aussparungen 27, 28, 29 in Form von Rillen 27 und Löchern 28, 29. Alternativ oder zusätzlich zu den Aussparungen 27, 28, 29 können auch Vorsprünge (nicht gezeigt) vorgesehen sein.

Die Ansicht der Fig. 3 entspricht dabei einem Schnitt entlang der Linie IV-IV aus Fig. 4, welche das entsprechende Modul 20 in Untersicht zeigt. Wie in Fig. 4 angedeutet, können die Aussparungen 27, 28, 29 verschiedenste Formen annehmen und über die gesamte Kontaktfläche angeordnet sein. Es ist weiterhin möglich, Aussparungen 27, 28, 29 verschiedener Tiefen vorzusehen. Die Aussparungen 27, 28, 29 können die Kontaktfläche in Form eines Musters räumlich strukturieren oder aber eher zufällig oder lediglich in vorgesehen Bereichen der Kontaktfläche angeordnet sein. Die Modulkontakteinrichtung 26 kann anstelle einer strukturierten Kontaktfläche auch aus einzelnen, von einander getrennten, von der Vergussfläche 22 hervorstehenden, eventuell selbst wieder räumlich strukturierten Kontaktelementen (nicht gezeigt) gebildet sein. Gemäß einer weiteren Ausführungsform (nicht gezeigt) kann entlang des Randes der Kontaktfläche zusätzlich ein umlaufender Wall ausgebildet sein, der sich beim Einbetten in Richtung der Komponentenkontakteinrichtung 32 erstreckt und dazu dient, das Einfließen von Kleber 60 (vgl. Fig. 6) oder dergleichen in die Aussparung 42 (vgl. Fig. 5) beim Einbetten und Verkleben des Moduls 20 in der Aussparung 40 (vgl. Fig. 5) des Datenträgerkörpers 12 zu verhindern.

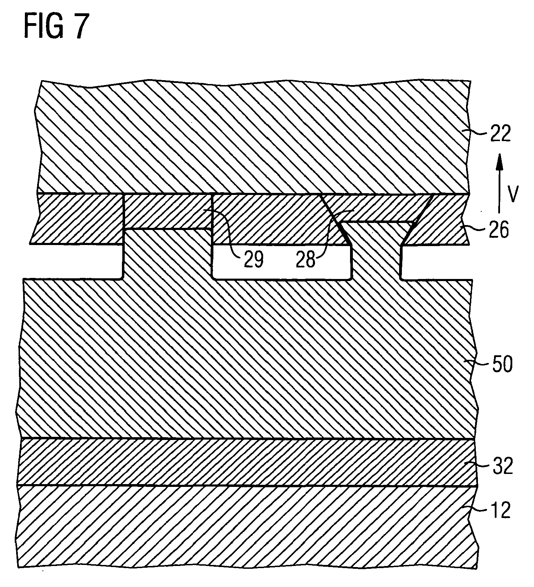

Wie in Fig. 3 gezeigt und in Fig. 4 durch die gestrichelten Linien angedeutet, sind einzelne der Aussparungen 27,28 derart ausgebildet, dass sie sich in Richtung von dem Vergusskörper weg, d.h. beim Einbetten des Moduls (vgl. Fig. 6, 7) in Richtung des elastischen Materials 50 bzw. der Komponentenkontakteinrichtung 32 hin verjüngen. Eine solche verjüngende Ausgestaltung kann für alle Aussparungen 27, 28, 29 vorgesehen sein oder aber lediglich für einige. Es sind auch Ausführungsformen der Modulkontakteinrichtung 26 möglich, die keine derart sich verjüngenden Aussparungen umfassen.

In Fig. 6 ist gezeigt, wie das Modul 20 aus Fig. 3 in die Aussparung 40 des Datenträgerkörpers 12 eingebettet und mittels eines geeigneten Klebers 60, beispielsweise eines Heißklebers, darin verklebt worden ist. Dabei ist das elastische, elektrisch leitfähige Material 50 durch die räumlich strukturierte Modulkontakteinrichtung 26 in Form der mit den Aussparungen 27, 28, 29 versehenen Kontaktfläche unter Druckbeaufschlagung geprägt worden und zeigt eine entsprechende räumliche Struktur auf der dem Modul 20 zugewandeten Seite. Der in dem Vergusskörper 22 vergossene integrierte Schaltkreis, welcher, wie erwähnt, mit der Modulkontakteinrichtung 26 elektrisch leitend verbunden ist, wird dadurch, über das elektrisch leitfähige Material 50 und die Komponentenkontakteinrichtung 32 mit der elektrischen Komponente 30, im gezeigten Beispiel der Antenne, elektrisch leitend verbunden.

Aufgrund der Elastizität des Materials 50, der Menge des in die Aussparung 42 eingebrachten Materials 50 sowie des Drucks durch die Kontaktfläche der Modulkontakteinrichtung 26 werden Anteile des Materials 50 in die Aussparungen 27, 28, 29 der Kontaktfläche des Moduls 20 eingepresst. Das Material 50 ist so gewählt, dass die eingeprägte Struktur auch bei nachlassender Druckbeaufschlagung durch die Modulkontakteinrichtung 26 im Wesentlichen erhalten bleibt. Dies ist in Fig. 7 exemplarisch gezeigt.

Der bezüglich Fig. 6 vergrößerte Ausschnitt in Fig. 7 veranschaulicht ein vertikales Verschieben des Moduls 20 (in Richtung des Pfeils V) relativ zu dem Datenträgerkörper 12 mit der Komponentenkontakteinrichtung 32 und dem elastischen, elektrisch leitfähigen Material 50. Lässt der Druck auf das Material 50 nach, wenn die Kontaktfläche der Modulkontakteinrichtung 26 zurückweicht, so entspannt sich das Material 50 in begrenztem Rahmen zu seiner Ausgangsdicke (vgl. Fig. 5). Schon aus diesem Grund kann der Kontakt zwischen der Modulkontakteinrichtung 26 und dem Material 50 bei geringfügiger Verschiebung des Moduls 20 erhalten bleiben. Ist diese Verschiebung allerdings zu stark, um alleine durch Elastizität des Materials 50 aufgefangen zu werden, so bleibt der Kontakt doch noch entlang der Flanken der räumlich geprägten Struktur in dem Material 50, welche sich entlang der Flanken der Aussparungen 28, 29 der Kontaktfläche der Modulkontakteinrichtung 26 bewegen, bestehen (vgl. Fig. 7). Dieser Effekt kann noch dadurch gesteigert werden, dass die Aussparungen 28 sich in Richtung des Materials 50 bzw. in Richtung der Komponentenkontakteinrichtung 32 hin verjüngen. In solche Aussparungen beim Einbetten des Moduls 20 eingepresstes Material 50 zieht sich bei Verschiebung des Moduls in vertikaler Richtung nur unter Widerstand aus der Aussparung 28 zurück. Auf diese Weise kann der Kontakt zwischen dem Modul 20 und der Komponente 30 über die entsprechenden Kontakteinrichtungen 32, 26 und das Material 50 auch bei starker mechanischer Belastung an den Datenträgerkörper 12 mit daraus resultierender Verschiebung des Moduls 20 relativ zum Datenträgerkörper 12 maximal lange aufrecht erhalten werden.

## Patentansprüche

1. Elektronisches Modul (20), geeignet zum zumindest teilweisen Einbetten in einen Datenträgerkörper (12) eines portablen Datenträgers (10), umfassend eine Modulkontakteinrichtung (26) zum elektrisch leitenden Verbinden des Moduls (20) mit einem elastischen, elektrisch leitfähigen Material (50) des Datenträgers (10), wobei die Modulkontakteinrichtung (26) derart räumlich strukturiert ausgebildet ist, dass sie geeignet ist, beim Einbetten des Moduls (20) in den Datenträgerkörper (12) unter Druckbeaufschlagung eine räumliche Struktur in das elastische, elektrisch leitfähige Material (50) einzuprägen, **dadurch gekennzeichnet, dass**
die Modulkontakteinrichtung (26) flächig ausgebildet ist und eine beim Einbetten dem elastischen Material (50) zugewandte Kontaktfläche der Modulkontakteinrichtung (26) durch Aussparungen (27; 28; 29) räumlich strukturiert ist,
wobei sich zumindest einige der Aussparungen (27; 28) in Richtung der beim Einbetten dem elastischen Material (50) zugewandten Seite der Kontaktfläche verjüngen.

2. Modul (20) nach Anspruch 1, **dadurch gekennzeichnet, dass** die Aussparungen (27; 28; 29) im Wesentlichen auf der gesamten Kontaktfläche der Modulkontakteinrichtung (26) verteilt sind.

3. Portabler Datenträger (10), umfassend einen Datenträgerkörper (12) mit einer elektrischen Komponente (30) sowie ein elektronisches Modul (20) gemäß dem Anspruch 1, wobei das Modul (20) zumindest teilweise in den Datenträgerkörper (12) eingebettet und über die Modulkontakteinrichtung (26) mittels eines elastischen, elektrisch leitfähigen Materials (50) unter Druckbeaufschlagung elektrisch leitend mit einer Komponentenkontakteinrichtung (32) der elektrischen Komponente (30) des Datenträgers (10) verbunden ist, und wobei in das elastische, elektrisch leitfähige Material (50) durch die räumlich strukturierte Modulkontakteinrichtung (26) eine räumliche Struktur eingeprägt ist.

4. Datenträger (10) nach Ansprüch 3, **dadurch gekennzeichnet, dass** das elastische, elektrisch leitfähige Material (50) derart ausgebildet ist, dass die durch die räumlich strukturierte Modulkontakteinrichtung (26) eingeprägte räumliche Struktur in dem Material (50) auch bei nachlassender Druckbeaufschlagung im Wesentlichen erhalten bleibt.

5. Verfahren zur Herstellung eines portablen Datenträgers (10) mit einem Datenträgerkörper (12) sowie einem elektronischen Modul (20), umfassend die Schritte:
- Anordnen eines elastischen, elektrisch leitfähigen Materials (50) in einer Aussparung (42) des Datenträgerkörpers (12) derart, dass das Material (50) mit einer Komponentenkontakteinrichtung (32) einer elektrischen Komponente (30) des Datenträgerkörpers (12) elektrisch leitend verbunden wird;
- zumindest teilweises Einbetten des Moduls (20) in den Datenträgerkörper (12) derart, dass das Material (50) die Komponentenkontakteinrichtung (32) und eine Modulkontakteinrichtung (26) des Moduls (20) unter Druckbeaufschlagung elektrisch leitend verbindet;
**dadurch gekennzeichnet, dass** die Modulkontakteinrichtung (26) räumlich strukturiert ausgebildet wird und das Material (50) beim Einbetten des Moduls (20) durch die Modulkontakteinrichtung (26) räumlich strukturiert geprägt wird.

6. Verfahren nach Anspruch 5, **gekennzeichnet durch** Schritte zum Herstellen eines Datenträgers (10) nach einem der Ansprüche 1 oder 2.

## Claims

1. An electronic module (20), suitable for being at least partially embedded in a data carrier body (12) of a portable data carrier (10), comprising a module contacting device (26) for electroconductive connection of the module (20) to an elastic, electroconductive material (50) of the data carrier (10), wherein the module contacting device (26) is configured in such a spatially structured fashion that it is suitable, upon the embedding of the module (20) in the data carrier body (12), for embossing a spatial structure in the elastic, electroconductive material (50) under the application of pressure, **characterized in that**
the module contacting device (26) is configured flatly and a contact surface of the module contacting device (26) facing the elastic material (50) upon embedding is spatially structured by recesses (27; 28; 29),
wherein at least some of the recesses (27; 28) taper in the direction of the side of the contact surface facing the elastic material (50) upon embedding.

2. The module (20) according to claim 1, **characterized in that** the recesses (27; 28; 29) are distributed substantially over the entire contact surface of the module contacting device (26).

3. A portable data carrier (10) comprising a data carrier body (12) with an electrical component (30) and an electronic module (20) according to claim 1, wherein the module (20) is embedded at least partially in the data carrier body (12) and is electroconductively connected to a component contacting device (32) of the electrical component (30) of the data carrier (10) via the module contacting device (26) by means of an elastic, electroconductive material (50) under the application of pressure, and wherein a spatial structure is embossed in the elastic, electroconductive material (50) by the spatially structured module contacting device (26).

4. The data carrier (10) according to claim 3, **characterized in that** the elastic, electroconductive material (50) is so configured that the spatial structure embossed in the material (50) by the spatially structured module contacting device (26) substantially remains also when the application of pressure decreases.

5. A method for manufacturing a portable data carrier (10) with a data carrier body (12) and an electronic module (20), comprising the steps of:
- arranging an elastic, electroconductive material (50) in a recess (42) of the data carrier body (12) in such a fashion that the material (50) is electroconductively connected to a component contacting device (32) of an electrical component (30) of the data carrier body (12);
- at least partial embedding of the module (20) in the data carrier body (12) in such a fashion that the material (50) electroconductively connects the component contacting device (32) and a module contacting device (26) of the module (20) under the application of pressure;
**characterized in that** the module contacting device (26) is configured to be spatially structured and the material (50) is embossed in spatially structured fashion by the module contracting device (26) upon embedding the module (20).

6. The method according to claim 5, **characterized by** steps for manufacturing a data carrier (10) according to any of the claims 1 or 2.

## Revendications

1. Module électronique (20) se prêtant à l'encastrement au moins partiel dans un corps de support de données (12) d'un support de données portable (10), comprenant un dispositif de contact de module (26) pour le raccordement électroconducteur du module (20) à un matériau (50) élastique électriquement conducteur du support de données (10), le dispositif de contact de module (26) étant réalisé de telle sorte de manière structurée dans l'espace que, lors de l'encastrement du module (20) dans le corps de support de données (12), il se prête sous application d'une pression à gaufrer une structure spatiale dans le matériau (50) élastique électriquement conducteur, **caractérisé en ce que**
le dispositif de contact de module (26) est réalisé sous forme étendue, et une surface de contact du dispositif de contact de module (26) tournée vers le matériau (50) élastique lors de l'encastrement est structurée dans l'espace par des évidements (27; 28; 29),
cependant qu'au moins quelques uns des évidements (27; 28) s'effilent en direction du côté de la surface de contact tournée vers le matériau (50) élastique lors de l'encastrement.

2. Module (20) selon la revendication 1, **caractérisé en ce que** les évidements (27; 28; 29) sont essentiellement répartis sur l'ensemble de la surface de contact du dispositif de contact de module (26).

3. Support de données portable (10), comprenant un corps de support de données (12) ayant un composant électrique (30) ainsi qu'un module électronique (20) selon la revendication 1, le module (20) étant encastré au moins partiellement dans le corps de support de données (12) et étant, par l'intermédiaire du dispositif de contact de module (26), au moyen d'un matériau (50) élastique électriquement conducteur, sous application d'une pression, raccordé de manière électroconductrice avec un dispositif de contact de composant (32) du composant électrique (30) du support de données (10), et une structure spatiale étant gaufrée, par le dispositif de contact de module (26) structuré dans l'espace, dans le matériau (50) élastique électriquement conducteur.

4. Support de données (10) selon la revendication 3, **caractérisé en ce que** le matériau (50) élastique électriquement conducteur est réalisé de telle façon que la structure spatiale gaufrée par le dispositif de contact de module (26) structuré dans l'espace se perpétue essentiellement dans le matériau (50) même quand l'application de pression est relâchée.

5. Procédé de fabrication d'un support de données portable (10) ayant un corps de support de données (12) ainsi qu'un module électronique (20), comprenant les étapes:
agencement d'un matériau (50) élastique électriquement conducteur dans un évidement (42) du corps de support de données (12), de telle façon que le matériau (50) est raccordé de manière électroconductrice avec un dispositif de contact de composant (32) d'un composant électrique (30) du corps de support de données (12);
encastrement au moins partiel du module (20) dans le corps de support de données (12), de telle façon que, sous application d'une pression, le matériau (50) raccorde de manière électroconductrice le dispositif de contact de composant (32) et un dispositif de contact de module (26) du module (20);
**caractérisé en ce que** le dispositif de contact de module (26) est réalisé de manière structurée dans l'espace et que le matériau (50) est, lors de l'encastrement du module (20), gaufré de manière structurée dans l'espace par le dispositif de contact de module (26).

6. Procédé selon la revendication 5, **caractérisé par** des étapes de la fabrication d'un support de données (10) selon une des revendications 1 ou 2.
